# FASCICULE DE BREVET EUROPEEN

(11) **EP 0 279 752 B1**
(45) Date de publication et mention de la délivrance du brevet: **05.05.1993**
(21) Numéro de dépôt: 88420017.1
(22) Date de dépôt: 21.01.1988
(51) Int. Cl.: H01L 21/90, H01L 27/04

(54) **Procédé de formation de trous de passage métallisés de hauteurs inégales**
Verfahren zum Herstellen von metallisierten Kontaktlöchern unterschiedlicher Höhe
Method of producing metallised through-holes with different heights

(30) Priorité: 23.01.1987 FR 8701095
(43) Date de publication de la demande: 24.08.1988
(73) Titulaire: FRANCE TELECOM, 75015 Paris (FR)
(72) Inventeur: FRANCE TELECOM, 75015 Paris (FR)
(74) Mandataire: de Beaumont, Michel

(56) Documents cités:
- US-A- 4 349 408
- IBM TECHNICAL DISCLOSURE BULLETIN, vol. 29, no. 1, juin 1986, pages 310-311, New York, US; "Variable depth contact hole preparation utilizing a nucleation layer and selective chemical vapor deposition for stud formation"
- J. VAC. SCI. TECHNOL. A, vol. 3, no. 6, novembre/décembre 1985, pages 2298-2302; J.-O. CARLSSON et al.: "Selective deposition of tungsten-prediction of selectivity"

## Description

La présente invention concerne le domaine de la fabrication des circuits semiconducteurs tels que des circuits intégrés. Elle concerne plus particulièrement la fabrication de dispositifs semiconducteurs à plusieurs couches de métallisation entre lesquelles sont prévus des trous de passage métallisés.

De façon générale, ces trous de passage métallisés sont destinés à faire un contact avec une deuxième couche de métallisation, couramment en aluminium.

Dans l'art antérieur, avec des circuits de relativement grandes dimensions, où les trous de passage avaient un diamètre supérieur à 2 microns, il était possible d'effectuer directement un dépôt d'aluminium qui servait à la fois de seconde couche de métallisation et de remplissage des trous de passage. Toutefois, cette solution ne fonctionne plus avec des circuits miniaturisés dans lesquels on arrive à des trous de passage de dimensions de l'ordre du micron ou moins.

Dans l'art antérieur, on a donc proposé pour remplir les trous de passage d'utiliser du tungstène qui présente une résistivité relativement forte. Avec du tungstène, deux types de procédés ont été mis en oeuvre.

Selon un premier type de procédé, on a déposé du tungstène par dépôt chimique en phase vapeur avec une couche d'accrochage sur la couche isolante et l'on a ainsi obtenu une relativement bonne planarisation de la couche de tungstène et un bon remplissage des trous de passage. Néanmoins, ce procédé n'a été utilisé que dans le cas de la première couche de métallisation d'une structure, cas dans lequel tous les trous ménagés dans l'isolant ont la même hauteur et éventuellement des diamètres différents.

Un autre type de procédé a consisté à utiliser les propriétés d'autolocalisation d'un dépôt de tungstène obtenu par voie chimique en phase vapeur. Dans ce cas, il apparaît que le tungstène se dépose sur la couche de métallisation existant au fond d'un trou de passage et pas sur la couche isolante. Ce procédé relativement délicat à mettre en oeuvre a toutefois donné satisfaction dans le cas où les diverses voies de passage présentent une même hauteur et éventuellement des diamètres différents. Toutefois, ce procédé ne convient plus quand les trous de passage ont des hauteurs distinctes.

Ainsi, un objet de la présente invention est de prévoir un nouveau procédé de formation et de remplissage de trous de passage dans le cas où la hauteur de ces trous est variable.

Pour atteindre cet objet, la présente invention prévoit un procédé de formation de trous de passage métallisés par du tungstène, ces trous ayant des diamètres de l' ordre du micromètre ou moins, vers une couche conductrice inférieure à travers une couche isolante d'épaisseur irrégulière, comprenant les étapes suivantes :
- déposer sur la couche isolante une couche d'accrochage pour le tungstène ;
- graver dans la couche isolante des trous de même diamètre, ce diamètre étant choisi supérieur à la moitié de l'épaisseur et inférieur au double de l'épalsseur de la couche de tungstène déposée à l'étape suivante ; et
- déposer, par voie chimique en phase vapeur, une couche de tungstène.

On notera que les trois étapes ci-dessus sont décrites dans le brevet US-A-4349408 dans une application autre que celle du remplissage de trous de passage.

La présente invention vise également à définir des règles de détermination des diamètres des trous en fonction du dépôt de tungstène effectué ultérieurement.

Ces objets, caractéristiques et avantages ainsi que d'autres de la présente invention seront exposés plus en détail dans la description suivante d'un mode de réalisation particulier faite en relation avec les figures jointes parmi lesquelles :
les figures 1A à 1D illustrent des étapes successives de mise en oeuvre d'un mode de réalisation du procédé selon la présente invention ; et
la figure 2 illustre un exemple d'appliclation du procédé selon la présente invention.

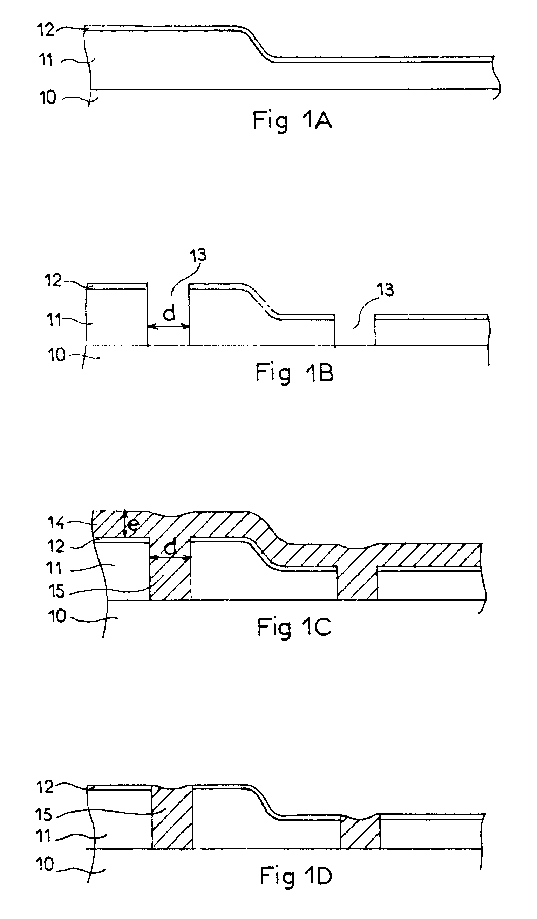

La figure 1A représente une structure à laquelle s'applique la présente invention. Cette structure comprend une couche supérieure conductrice 10 sur laquelle est formée une couche isolante 11, couramment de la silice (SiO₂). Dans une première étape, on prévoit selon la présente invention de déposer sur la couche de silice 11 une couche de silicium polycristallin 12, destinée l'accrochage du tungstène déposé ultérieurement.

Dans une deuxième étape, illustrée en figure 1B, on ouvre dans la couche isolante 11 des fenêtres 13 correspondant à des trous ayant tous le même diamètre d. Cette gravure peut, par exemple, être effectuée de façon classique par masquage et attaque ionique réactive.

Dans une troisième étape, illustrée en figure 1C, on dépose par voie chimique en phase vapeur, par exemple à partir de WF₆ une couche de tungstène 14 d'épaisseur e. Par la même occasion, les ouvertures 13 sont remplies de tungstène 15. On s'aperçoit que les voies de passage sont complètement remplies et que la couche de tungstène supérieure a une épaisseur constante.

Dans une dernière étape, on grave la couche de tungstène sur une épaisseur e pour obtenir simplement la structure de la figure 1D avec les voies de passage remplies de tungstène.

On notera que la dernière étape est susceptible de variantes. Par exemple, il aurait été possible de masquer la couche de tungstène 14 avant de procéder à la gravure pour laisser en place des îlots ou des languettes de tungstène destinés à faciliter certaines connexions ultérieures. De même, la couche d'accrochage de silicium polycristallin 12 a été représentée comme maintenue en place en figure 1D. On pourra bien entendu l'éliminer localement ou totalement.

Parmi les étapes mentionnées ci-dessus du procédé selon l'invention, on soulignera plus particulièrement l'étape de la figure 1A qui consiste à prévoir une couche d'accrochage en silicium polycristallin. L'expérience montre qu'une telle couche d'accrochage est particulièrement efficace pour obtenir une croissance régulière du tungstène déposé par voie chimique en phase vapeur. Un avantage de la prévision d'une telle couche d'accrochage est qu'elle peut être déposée dans le même four que celui qui sert ultérieurement au dépôt de tungstène. Le dépôt de silicium polycristallin peut se faire par exemple à partir de silane à une température voisine de 600°C, le dépôt de tungstène se faisant ensuite à partir du WF₆ à une température voisine de 400°C.

Avec une épaisseur de silicium polycristallin comprise entre 80 et 100 nanomètres, on peut ensuite développer des couches de tungstène de bonne adhérence d'une épaisseur comprise entre 350 et 800 nm.

Selon un autre aspect de l'invention, il importe que tous les diamètres des trous formés dans la couche isolante 11 soient égaux entre eux. En outre, le diamètre choisi doit être au plus égal au double de l'épaisseur de la couche de tungstène déposée pour assurer un bon remplissage. Ainsi, la présente invention permet de choisir des diamètres égaux entre eux dans une plage allant d'environ 500 à environ 1500 nm. Avec de telles valeurs, on a observé un remplissage satisfaisant sans lacunes ni irrégularités, avec une bonne planéité de surface de la couche de tungstène pour des profondeurs de voies de passage variant d'un emplacement à l'autre d'une plaquette entre 200 et 800 nm.

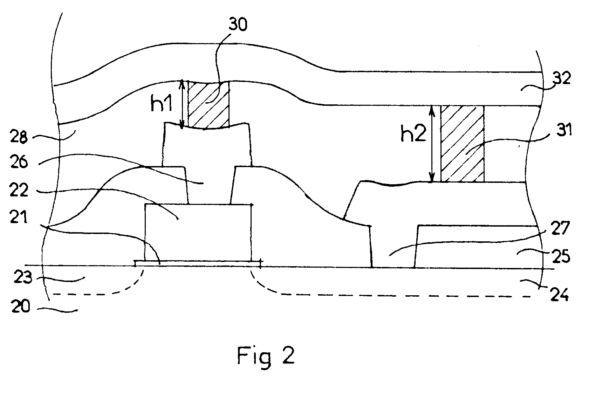

La figure 2 illustre un exemple d'application de la présente invention à un transistor MOS d'un circuit intégré. Ce transistor comprend sur un substrat 20 une couche d'isolement de grille 21 recouverte d'une grille conductrice 22 constituée de la superposition d'une couche de silicium polycristallin et d'un siliciure. Dans le substrat, selon une région masquée par la grille 22, sont formés un drain 23 et une source 24. Ensuite, l'ensemble de la grille et du substrat est revêtu d'une première couche isolant 25 dans laquelle sont prévues une ouverture de contact de grille 26 et une ouverture de contact de source 27, ces ouvertures étant surmontées de zones métallisées correspondant à un premier niveau de métallisation. Ensuite, est déposée une couche ou plutôt un ensemble de couches isolantes 28 destinées à planariser le dispositif, c'est-à-dire à rendre sa surface plus lisse. Comme exemple d'un tel ensemble de couches de planarisation, on peut citer un sandwich dont au moins une couche comprend du verre en suspension déposé à la tournette (couramment désigné dans la technique par le sigle SOG d'après l'appellation anglo-saxonne spin on glass). Ainsi, quand on veut percer des voies de passage 30 et 31 dans la couche isolante 28 pour rejoindre les métallisations 26 et 27, on s'aperçoit que ces voies de passage ont des hauteurs h1 et h2 distinctes. La présente invention permet de remplir ces voies de passage de tungstène selon le procédé exposé précédemment à condition de prévoir des diamètes identiques pour les deux voies de passage.

Enfin, la figure 2 représente une couche finale de métallisation ou deuxième niveau de métallisation 32 entrant en contact avec la surface supérieure des voies de passage métallisées 30 et 31. Cette couche de métallisation peut ensuite être gravée de façon sélective.

Dans la pratique, le premier niveau de métallisation assurant le remplissage des ouvertures 26 et 27 dans la première couche isolante 25 peut lui-même être constitué de tungstène déposé de la façon indiquée précédemment, c'est-à-dire déposé par voie chimique en phase vapeur à faible pression. Or, il s'avère dans la pratique que des couches de tungstène déposées de cette façon présentent de façon notable une structure cristalline orientée (100). Cette structure n'est pas monocristalline mais est constituée d'un ensemble de grains. Etant donné l'orientation (100) dominante de ces grains, le matériau déposé à la surface supérieure du dispositif est fortement susceptible de diffuser verticalement dans le tungstène alors que les diffusions latérales sont moins favorisées. Ainsi, si la couche finale de métallisation 32 est de l'aluminium, aux endroits où les trous de passage successifs (31, 27) débouchent sur une zone susceptible d'être affectée de façon néfaste dans ses caractéristiques électriques par une diffusion d'aluminium, ce qui est le cas du contact de source 24-27, on prévoiera un décalage latéral entre les trous de passage correspondants 31 et 27. Ce décalage doit de préférence être au moins égal à deux fois la somme des diamètres des trous de contact.

## Revendications

1. Procédé de formation de trous de passage métallisés par du tungstène, ces trous ayant des diamètres de l'ordre du micromètre ou moins, vers une couche conductrice inférieure à travers une couche isolante d'épaisseur irrégulière, comprenant les étapes suivantes :
- déposer sur la couche isolante (11) une couche d'accrochage (12) pour le tungstène ;
- graver dans la couche isolante des trous (13) de même diamètre, ce diamètre (d) étant choisi supérieur à la moitié de l'épaisseur et inférieur au double l'épaisseur (e) de la couche de tungstène déposée à l'étape suivante ; et
- déposer, par voie chimique en phase vapeur, une couche de tungstène (14).

2. Procédé selon la revendication 1, caractérisé en ce qu'il comprend en outre l'étape consistant à graver la couche de tungstène (14) déposée sur la couche isolante.

3. Procédé selon la revendication 2, caractérisé en ce que ladite gravure de la couche de tungstène est localisée.

4. Procédé selon la revendication 1, caractérisé en ce que la couche d'accrochage (12) est une couche de silicium polycristallin.

5. Procédé selon la revendication 1, caractérisé en ce que le tungstène est déposé par voie chimique en phase vapeur à partir de WF6.

6. Procédé selon les revendications 4 et 5, caractérisé en ce que les dépôts de silicium polycristallin puis de tungstène sont réalisés successivement dans un même réacteur.

7. Procédé selon l'une quelconque des revendications 1 à 6, caractérisé en ce que la couche de tungstène a une épaisseur comprise entre 350 et 800 nm et en ce que les trous dans la couche isolante ont un diamètre compris de façon correspondante entre au plus 700 nm et au plus 1600 nm.

8. Procédé selon l'une quelconque des revendications 1 à 7, dans lequel la couche conductrice inférieure est elle-même une couche de tungstène déposée sur une couche isolante (25) munie de trous de passage inférieurs vers des zones à contacter, caractérisé en ce que, quand une zone à contacter (24) est susceptible d'être altérée par diffusion d'un matériau déposé au-dessus des trous de passage supérieurs, les trous de passage supérieurs (31) et inférieurs (27) sont décalés d'une distance latérale entre axes supérieure à deux fois la somme de leurs diamètres.

## Claims

1. A method for forming tungsten-metallized vias, said vias having a diameter of about one micrometer less, towards lower conductive layer across an insulating layer having a non constant thickness, comprising the following steps:
- depositing on the insulating layer (11) a tungsten fastening layer (12);
- etching in said insulating layer holes (13) having a same diameter, said diameter (d) being greater than half of the thickness and smaller than twice the thickness (e) of the tungsten layer deposited at the following step; and
- depositing by chemical vapor deposition, a tungsten layer (14).

2. A method according to claim 1, characterized in that it further comprises the step of etching the tungsten layer (14) deposited on the insulating layer.

3. A method according to claim 2, characterized in that said etching of the tungsten layer is localized.

4. A method according to claim 1, characterized in that said fasting layer (12) is a polysilicon layer.

5. A method according to claim 1, characterized in that said chemical vapor deposition of tungsten is made from WF₆.

6. A method according to claims 4 and 5, characterized in that said polysilicon and tungsten deposition are successively realized in a same reactor.

7. A method according to any of claims 1 to 6, characterized in that said tungsten layer has a thickness comprised between 350 and 800 nm and in that the holes in the insulating layer have a diameter correspondingly comprised between at most 700 nm and at most 1,600 nm.

8. A method according to any of claims 1 to 7, wherein the lower conductive layer is itself a tungsten layer deposited on an insulating layer (25) provided with lower vias towards areas to be contacted, characterized in that, when an area (24) to be contacted is liable to be impaired by the indiffusion of a material deposited above the upper vias, the upper (31) and lower (27) vias are shifted by a lateral interaxis distance higher than twice the sum of their diameters.

## Patentansprüche

1. Verfahren zum Ausbilden von Kontaktlöchern, die mit Wolfram metallisiert sind und Durchmesser in der Größenordnung von Mikrometern oder weniger haben, zu einer unteren leitenden Schicht durch eine isolierende Schicht mit unregelmäßiger Dicke hindurch, mit folgenden Schritten:
- Aufbringen einer Haftschicht (12) für das Wolfram auf die isolierende Schicht (11);
Ätzen von Löchern (13) gleichen Durchmessers in die isolierende Schicht, wobei dieser Durchmesser (d) größer als die halbe Dicke und kleiner als die doppelte Dicke (e) der im folgenden Schritt abgeschiedenen Wolframschicht (14) gewählt ist; und
Abscheiden einer Wolframschicht (14) mittels chemischen Abscheidens aus der Dampfphase.

2. Verfahren nach Anspruch 1, dadurch gekennzeichnet, daß ferner der Schritt vorgesehen ist, die auf der isolierenden Schicht abgeschiedene Wolframschicht (14) zu ätzen.

3. Verfahren nach Anspruch 1, dadurch gekennzeichnet, daß das Ätzen der Wolframschicht lokalisiert erfolgt.

4. Verfahren nach Anspruch 1, dadurch gekennzeichnet, daß die Haftschicht (12) eine polykristalline Siliziumschicht ist.

5. Verfahren nach Anspruch 1, dadurch gekennzeichnet, daß das Wolfram aus WF₆ aus der Dampfphase chemisch abgeschieden wird.

6. Verfahren nach den Ansprüchen 4 und 5, dadurch gekennzeichnet, daß das Aufbringen von polykristallinem Silicium und Wolfram nacheinander in demselben Reaktor erfolgt.

7. Verfahren nach einem der Ansprüche 1 bis 6, dadurch gekennzeichnet, daß die Wolframschicht eine Gesamtdicke zwischen 350 und 800 nm hat, und daß die Löcher in der isolierenden Schicht einen entsprechenden Gesamtdurchmesser zwischen höchstens 700 nm und höchstens 1600 nm haben.

8. Verfahren nach einem der Ansprüche 1 bis 7, wobei die leitende untere Schicht selbst eine Wolframschicht ist, die auf eine isolierende Schicht (25) aufgebracht ist, welche mit unteren Kontaktlöchern zu Kontaktzonen versehen ist, dadurch gekennzeichnet, daß dann, wenn eine Kontaktzone (24) empfindlich gegenüber einer Schädigung durch Diffusion eines auf den oberen Kontaktlöchern abgeschiedenen Materiales ist, die oberen und unteren Kontaktlöcher (31, 27) gegeneinander mit einem Abstand zwischen ihren Achsen verschoben sind, der größer als die doppelte Summe ihrer Durchmesser ist.
